# Europäisches Patentamt
## European Patent Office
## Office européen des brevets

(19)

(11) Veröffentlichungsnummer: **0 133 621**
**B1**

(12)

# EUROPÄISCHE PATENTSCHRIFT

(45) Veröffentlichungstag der Patentschrift:
30.03.88

(21) Anmeldenummer: 83107604.7

(22) Anmeldetag: 02.08.83

(51) Int. Cl.⁴: **H 05 K 3/08, C 23 F 1/00,**
**H 01 L 21/31**

(54) Verfahren zum Trockenätzen von Kupfer und seine Verwendung.

(43) Veröffentlichungstag der Anmeldung:
06.03.85 Patentblatt 85/10

(45) Bekanntmachung des Hinweises auf die Patenterteilung:
30.03.88 Patentblatt 88/13

(84) Benannte Vertragsstaaten:
DE FR GB

(56) Entgegenhaltungen:
EP - A - 0 054 663

IBM TECHNICAL DISCLOSURE BULLETIN, Band 22, Nr. 8A, Januar 1980, Seite 3196, New York, USA, C. CRIMI et al.: "Etching of aluminum and aluminum-copper alloys"
CHEMICAL ABSTRACTS, Band 96, Nr. 10, 8. März 1982, Seite 669, Nr. 78537g, Columbus, Ohio, USA, T. KAWAGUCHI et al.: "Chemical change of copper thin film by Freon plasma" & IONGEN TO ION OKISO TOSHITA OYO GIJUTSU, SHINPOJUMU, 5th 1981, 5-8
CHEMICAL ABSTRACTS, Band 92, Nr. 2, 14. Januar 1980, Seite 523, Nr. 14200b, Columbus, Ohio. USA, R.N. CASTELLANO: "Reactive sputtering and sputter etching of thin films by ion beam bombardment" & VIDE ,COUCHES MINCHES 1979, 196, Suppl., 393-400

(73) Patentinhaber: IBM DEUTSCHLAND GMBH, Pascalstrasse 100, D-7000 Stuttgart 80 (DE)

(84) Benannte Vertragsstaaten: DE

(73) Patentinhaber: International Business Machines Corporation, Old Orchard Road, Armonk, N.Y. 10504 (US)

(84) Benannte Vertragsstaaten: FR GB

(72) Erfinder: Druschke, Frank, Dr. Dipl.-Chem., Kauzenhecke 3, D-7000 Stuttgart 70 (DE)
Erfinder: Kraus, Georg, Im Heinental 70, D-7277 Wildberg 4 (DE)
Erfinder: Künzel, Ulrich, Dr. Dipl.-Chem., August Lämmlestrasse 8, D-7408 Kusterdingen (DE)
Erfinder: Ruh, Wolf-Dieter, Dipl.-Ing-, Sommerhofenstrasse 152/1, D-7032 Sindelfingen (DE)
Erfinder: Schäfer, Rolf, Dr. Dipl.-Mineraloge, Ritterstrasse 25, D-7031 Gärtringen-Rohrau (DE)

(74) Vertreter: Oechssler, Dietrich, Dr. rer. nat., IBM Deutschland GmbH Patentwesen und Urheberrecht Schönaicher Strasse 220, D-7030 Böblingen (DE)

## Beschreibung

Die Erfindung betrifft ein Verfahren zum Trokkenätzen von Kupfer in einer Glimmentladung, welche organische Verbindungen enthält, und eine Verwendung des Verfahrens.

Kupfer wird aufgrund seiner sehr guten elektrischen Eigenschaften als Leiterzugmaterial bei der Herstellung von leitenden Verbindungen auf Modulsubstraten, Schaltkarten und Dünnfilmmagnetköpfen in grossem Umfang eingesetzt. Die Herstellung der leitenden Verbindungen erfolgt dabei üblicherweise aus einer aufgebrachten Kupferschicht auf photolithographischem Weg. Bevorzugt wird bei dem genannten Herstellungsweg die Kupferschicht, nachdem auf ihr ein den leitenden Verbindungen entsprechendes Muster aus Photolack erzeugt worden ist, selektiv weggeätzt, wobei das Muster der leitenden Verbindungen übrig bleibt. Zum Ätzen des Kupfers werden heute noch weitgehend nasschemische Prozesse eingesetzt. Mit der zunehmenden Mikrominiaturisierung elektronischer Schaltungen wird es jedoch zunehmend schwieriger auf nasschemischem Weg Leitermuster mit der erforderlichen Genauigkeit zu erzeugen. Es kommt hinzu, dass aus den Ätzbädern Verunreinigungen auf den zu ätzenden Teilen abgeschieden werden, wobei diese Verunreinigungen auch wegen der zunehmenden Mikrominiaturisierung immer weniger toleriert werden können. Aus diesem Grund wurde bereits versucht, brauchbare Trockenätzprozesse für Kupfer zu entwickeln. So ist es aus dem Artikel «Surface texturing of copper by sputter etching with applications for solar selective adsorbing surfaces» von P.M. Curmi und G.L. Harting, veröffentlicht im Journal of Vacuum Science Technology, Band 17 (6), November/Dezember 1980, Seiten 1320 ff. bekannt, Kupfer mittels Kathodenzerstäubung in einer Argonatmosphäre abzutragen. Selbstverständlich hat dieses Verfahren alle Nachteile, welche dem Kathodenzerstäubungsätzen eigen sind, d.h. insbesondere dass das abgetragene Material mindestens teilweise auf den zu ätzenden Teilen wieder abgeschieden wird. Ausserdem lagen bei den Untersuchungen die Temperaturen, auf welche die Kupferproben während des Ätzens mindestens erhitzt wurden; zwischen 300 und 400°C bei einem Schwankungsbereich von ± 50°C. Da jedoch bei fast allen Anwendungen das Kupfer selektiv mit einer Polymerschicht abgedeckt ist und/oder auf einer Kunststoffunterlage aufliegt, dürfen Temperaturen von 400°C beim Ätzen auf keinen Fall überschritten werden, und es ist wünschenswert, dass die angewandten Temperaturen wesentlich niedriger liegen.

Es wurden auch das Plasmaätzen und das reaktive Ionenätzen zum Ätzen von Kupfer eingesetzt. Diese Verfahren werden bei einer grossen Anzahl von Metallen mit grossem Erfolg angewandt, wobei als Ätzreagenzien üblicherweise Halogen-Verbindungen eingesetzt werden. Bei Kupfer ist dabei die Schwierigkeit, dass seine Halogen-Verbindungen erst bei relativ hohen Temperaturen flüchtig sind. So ist ein Plasmaätzprozess für Kupfer beschrieben worden, bei welchem das Ätzreagenz aus Jod besteht, welches mit dem Kupfer Kupfer-Jodid bildet, welches jedoch erst bei Temperaturen oberhalb 500°C flüchtig ist. Deshalb ist dieses Verfahren für die oben angegebenen Anwendungen nicht geeignet. In der europäischen Patentanmeldung 00 54 663 ist ausserdem ein Verfahren zum Entfernen von Kupfer mittels reaktiven Ionenätzens in einer Tetrachlorkohlenstoff und Alkohol enthaltenden Atmosphäre beschrieben. Auch bei diesem Verfahren liegen die erforderlichen Temperaturen bei $\geqslant 225°C$, ausserdem degradieren hierbei organische Polymere, welche als Masken oder Unterlagen benutzt werden.

Es ist die Aufgabe der Erfindung, ein Verfahren zum Trockenätzen von Kupfer, bei welchem der Abtrag des Kupfers mindestens teilweise chemisch erfolgt, und welches bei möglichst niedrigen Temperaturen abläuft und eine Anwendung dieses Verfahrens anzugeben.

Diese Aufgabe wird mit einem Verfahren der eingangs genannten Art mit dem Merkmal des kennzeichnenden Teils des Patentanspruchs 1 und mit einer Verwendung der eingangs genannten Art mit den Merkmalen des kennzeichnenden Teils des Patentanspruchs 13 gelöst.

Der Reaktionsmechanismus ist nicht bekannt. Zwar wird in dem Buch «The Chemistry of Organometallic Compounds» von E.G. Rochow u.a. S. 253 vermutet, dass sich $CH_3Cu$ bildet, wenn Kupfer einer strömenden Atmosphäre von Methylchlorid ausgesetzt wird, wobei ein Transport von Kupfer stattfindet. Aber es ist eher unwahrscheinlich, dass die in dem Buch beschriebenen Reaktionen mit den bei dem erfindungsgemässen Verfahren ablaufenden etwas zu tun haben, da Rochow nicht in einer Glimmentladung gearbeitet hat. Bei dem erfindungsgemässen Verfahren werden polymere Schichten nicht angegriffen. Daraus resultiert in vorteilhafter Weise die Möglichkeit, das erfindungsgemässe Verfahren auch dann einzusetzen, wenn Kupfer geätzt werden soll, welches – um eine selektive Ätzung durchzuführen – teilweise mit einer Maske aus einem Photolack oder einem anderen Polymermaterial abgedeckt ist und/oder auf einer Unterlage aus einem Polymermaterial aufgebracht ist. Bei dem erfindungsgemässen Verfahren wird Kupfer – und zwar bei einer sehr geringen Leistung – bereits bei Temperaturen unter 80°C mit einer beachtlichen Geschwindigkeit (0,2 – 1,0 nm/sec) abgetragen, während die in dem zitierten Buch beschriebenen Reaktionen bei Temperaturen zwischen 250 und 300°C stattfinden. Eine Erhöhung der Abtragungsgeschwindigkeit lässt sich durch eine Erhöhung der Leistung und/oder der Temperatur erreichen. Dadurch ist das erfindungsgemässe Verfahren insbesondere anwendbar bei der Herstellung von Leiterzügen auf oder in Modulsubstraten und Schaltkarten, von Lötpunkten und der Verdrahtung für Dünnfilmmagnetköpfen.

Das erfindungsgemässe Verfahren lässt sich in vorteilhafter Weise sowohl in der Form des Plasmaätzens als auch in der Form des reaktiven Ionenätzens einsetzen.

Weitere vorteilhafte Ausgestaltungen des erfindungsgemässen Verfahrens ergeben sich aus den Unteransprüchen.

Die Erfindung wird anhand von Ausführungsbeispielen beschrieben.

Das erfindungsgemässe Trockenätzverfahren lässt sich in der Form aller Trockenätzverfahren durchführen, bei welchen ein chemischer Angriff auf das zu ätzende Material erfolgt. Im folgenden wird das erfindungsgemässe Verfahren an den Beispielen des Plasmaätzens und des reaktiven Ionenätzens näher beschrieben, da sich an diesen beiden Trockenätzverfahren alle Besonderheiten des erfindungsgemässen Verfahrens aufzeigen lassen. Das reaktive Ionenätzen und ein dafür brauchbarer Reaktor sind beispielsweise in dem US-Patent 3 994 793 beschrieben. Ein solcher Reaktor weist eine Reaktionskammer auf, welche von einem geerdeten und mindestens einen Gaseinlass und einen Gasauslass aufweisenden Gehäuse umgeben ist, und in welcher eine plattenförmige Kathode horizontal angeordnet ist, auf welcher die zu ätzenden Substrate liegen. An der Kathode liegt eine hochfrequente Spannung. Das Gehäuse des Reaktors bildet die Anode, und zwischen Anode und Kathode wird während des Ätzens ein aus einer ein reaktives Gas enthaltenden Atmosphäre ein Plasma erzeugt, in welchem die ionisierten Teilchen hergestellt werden, welche die Ätzung bewirken. Beim reaktiven Ionenätzen, welches bevorzugt dann angewandt wird, wenn Strukturen mit exakt vertikalen Seitenwänden geätzt werden sollen, sind neben einer grossen mittleren freien Weglänge der ionisierten Teilchen, was durch einen entsprechend kleinen Druck in der Reaktionskammer erreicht wird, ionisierte Teilchen mit einer hohen kinetischen Energie wünschenswert. Der Abtrag des zu ätzenden Materials erfolgt einerseits physikalisch, d.h. aufgrund der kinetischen Energie der auftreffenden ionisierten Teilchen und andererseits chemisch, d.h. aufgrund einer Reaktion der im Plasma gebildeten ionisierten Teilchen mit dem zu ätzenden Material (ioneninduziertes chemisches Ätzen). Je nachdem, welcher der beiden Vorgänge geschwindigkeitsbestimmend beim Abtrag eines bestimmten Materials ist, spricht man von einem überwiegend physikalisch oder einem überwiegend chemisch ätzbaren Material.

Zum Plasmaätzen lässt sich beispielsweise ein Reaktor verwenden, der im US-Patent 3 757 733 beschrieben ist. Er weist in einer Reaktionskammer zwei plattenförmige, beispielsweise runde, parallel zueinander angeordnete und übereinanderliegende Elektroden auf. Der Reaktionsraum hat mindestens einen Gaseinlass und einen mit einer Vakuumpumpe verbundenen Gausauslass. Die obere der Elektroden liegt an einer hochfrequenten Wechselspannung. Auf der unteren Elektrode befinden sich die zu ätzenden Substrate. In der Mitte der unteren Elektrode befindet sich eine Öffnung, durch die das beim Verarbeiten benötigte Gas entweder in den Raum zwischen den Elektroden eingeleitet oder aus diesem Raum abgesaugt wird. Diese Anordnung stellt sicher, dass während der Ätzoperation über die Substrate ein kontinuierlicher Gasstrom entweder vom Rand des Elektrodenraums zur Öffnung in der unteren Elektrode oder in umgekehrter Richtung strömt. Während des Ätzens wird zwischen den Elektroden eine Glimmentladung aufrechterhalten, welche – wie beim reaktiven Ionenätzen – eine doppelte Wirkung hat. Einerseits werden die Substrate mit Gaspartikeln «bombardiert», welche aufgrund des zwischen den Elektroden vorhandenen elektrischen Feldes eine hohe kinetische Energie aufweisen und andererseits werden Gasatome bzw. -moleküle in der Glimmentladung ionisiert oder mindestens chemisch angeregt. Je nachdem welches Material geätzt werden soll, bzw. mit welchem Material beschichtet werden soll, werden die zu verwendenden Gase ausgewählt. Beim Plasmaätzen bewirken die chemischen Reaktionen der Ätzspezies mit den zu ätzenden Substraten als auch die Bombardierung mit ionisierten Gasteilchen eine chemisch-physikalische Abtragung des zu ätzenden Materials.

Zum Plasmaätzen ist auch eine Apparatur geeignet, welche in dem US-Patent 3 795 557 beschrieben ist. Bei dieser Apparatur befinden sich die zu ätzenden Teile in einem liegenden, zylindrischen Gefäss, welches mit einem Deckel gasdicht verschliessbar ist und welches mindestens einen Gaseinlass für die reaktiven Gase und einen an eine Vakuumpumpe angeschlossenen Gasauslass aufweist. Auf die Aussenfläche des zylindrischen Gefässes ist eine mit einem HF-Generator verbundene Spule gewickelt, durch welche die notwendige Energie, um in dem Reaktionsgefäss ein Plasma aufrechtzuerhalten, zugeführt wird. Das Plasmaätzen findet in dieser Apparatur prinzipiell in derselben Weise statt, wie in dem weiter oben beschriebenen Plasmareaktor.

Mit dem erfindungsgemässen Verfahren werden Strukturen in Kupferkörper geätzt. Bevorzugt liegt das Kupfer in Form von Kupferblech oder von dünnen auf Substrate aufgebrachte Schichten vor. Die Kupferschichten werden auf die Substrate beispielsweise durch Aufdampfen, durch stromlose oder elektrolytische Abscheidung oder durch das Auflaminieren von Kupferfolien aufgebracht. Das Substrat kann aus irgendeinem Material bestehen, welches unter den Bedingungen, unter denen das erfindungsgemässe Verfahren abläuft, nicht oder in nicht nennenswerter Weise angegriffen werden. Solche Materialien sind z.B. Kunststoffe, einige Metalle und Keramikmaterialien. Die Ätzung des Kupfers kann ganzflächig oder selektiv erfolgen. Im letzteren Fall werden diejenigen Bereiche der Kupferoberfläche, welche nicht geätzt werden sollen, mit einer Ätzmaske abgedeckt. Bevorzugt besteht die Maske aus einem Polymermaterial beispielsweise aus einem der üblichen Photolacke oder aus Polyimid. Wie schon gesagt, werden diese Materialien bei dem erfindungsgemässen Verfahren praktisch nicht angegriffen.

Die zu ätzenden Kupferkörper, beispielsweise auf einem Kunststoffsubstrat aufgebrachte Kupferschichten werden in die Reaktionskammer eines der oben angegebenen Reaktoren gelegt. Dann wird auf einen Druck im Bereich zwischen 0,0133 und 1,33 mbar abgepumpt. In die Reaktionskammer wird anschliessend das Ätzgas entweder in reiner Form oder vermischt mit einem Trägergas geleitet. Liegt der Siedepunkt der zum Ätzen verwendeten Verbindung unterhalb Raumtemperatur, so wird eine das Gas enthaltende Gasflasche an die Reaktionskammer angeschlossen, liegt der Siedepunkt oberhalb Zimmertemperatur, so wird der Dampf, welcher sich aufgrund des Dampfdrucks der in flüssiger Form vorliegenden Verbindung bildet, laufend in die Reaktionskammer gesaugt, Wird ein Gemisch aus Ätzgas und Trägergas verwendet, so werden Trägergas und reaktives Gas vor dem Eintritt in die Reaktionskammer homogen vermischt.

Als reaktive Gase bzw. Verbindungen werden solche verwendet, welche mindestens eine Methyl- oder Methylen-Gruppe enthalten. Bevorzugt werden Verbindungen aus der Gruppe Methylchlorid, Methylbromid, Methyljodid, Azeton, Dibutandiole, Methanol und Diazomethan verwendet. Als Trägergase sind und Inertgase, wie z.B. Argon und Stickstoff, geeignet. Während des Ätzens wird die Temperatur der Kupferteile auf einer Temperatur zwischen 40° und 200°C, bevorzugt bei ungefähr 50°C gehalten. Die angewandte HF-Leistung liegt zwischen 0,5 und 4 $W/cm^2$ und bevorzugt unterhalb 1 $W/cm^2$. Unter den angegebenen Bedingungen liegt die Ätzgeschwindigkeit zwischen 0,2 und 1,0 nm/sec. Die Ergebnisse waren gut reproduzierbar und es wurde keine Redeposition von Kupfer, und auch dann, wenn das zu ätzende Kupfer auf einem Kunststoffsubstrat aufgebracht war und/oder teilweise mit einer Maske aus einem Polymermaterial abgedeckt war, keine Polymerabscheidung festgestellt. Aus diesen Ergebnissen lässt sich ableiten, dass bei der Ätzung leichtflüchtige Kupferverbindungen gebildet werden und dass Kunststoffmaterialen nicht angegriffen werden. Daraus folgt bereits, dass, wenn beispielsweise als Ätzverbindung ein Methylhalogenid verwendet wird, keine Bildung eines Kupferhalogenids stattfindet, weil Kupferhalogenide schwer flüchtig sind. Möglicherweise ist es so, dass sich in der Glimmentladung Methyl- oder Methylene-Radikale bilden, welche mit dem Kupfer entweder direkt oder über Zwischenstufen leichtflüchtige Verbindungen bilden, und gegenüber Kunststoffmaterialen – verständlicherweise – weitgehend inert sind. Bei den bisher durchgeführten Versuchen mit Methylhalogeniden wurde auch keine Reaktion des Halogens mit dem Polymermaterial festgestellt. Um eine solche Reaktion auch in einem sehr geringen Ausmass mit Sicherheit auszuschliessen, kann dem Reaktionsgas Wasserstoff zugemischt werden.

Das erfindungsgemässe Verfahren ist vorteilhaft einsetzbar bei der Herstellung von Kupferleiterzügen auf bzw. in (soweit es sich um mehrschichtige handelt) Keramikbauteilen und Schaltkarten, von Lötpunkten und der Verdrahtung für Dünnfilmmagnetköpfe.

Im folgenden wird das erfindungsgemässe Verfahren anhand von zwei speziellen Beispielen noch deutlicher beschrieben:

Beispiel 1

Die Ätzung wurde in einem Reaktor, wie er in der US-Patentschrift 3 795 557 beschrieben ist, an auf Kunststoff- oder Glassubstraten aufgedampften Kupferfilmen durchgeführt. Als Ätzverbindung wurde reines Methyljodid verwendet. Der Fluss des (gasförmigen) Methyljodids war auf ungefähr 20 $cm^3$/Min. eingestellt. Die zu ätzenden Kupferfilme befanden sich innerhalb des Bereichs einer den Glasreaktor umgebenden 6 cm langen HF-Spule (induktive Energiekopplung). Der Glasreaktor hatte einen Druckmesser von ungefähr 40 mm. Der Druck im Glasreaktor betrug 0,04 mbar. Die HF-Leistung war auf 0,8 $W/cm^2$ eingestellt. Die gemessene Substrattemperatur lag bei ungefähr 50°C. Das Kupfer wurde mit einer Geschwindigkeit von ungefähr 0,6 nm/sec geätzt. Eine Redeposition von Kupfer und – bei der Verwendung von Kunststoffsubstraten – eine Polymerabscheidung wurde nicht festgestellt.

Beispiel 2

Die beim Beispiel 2 angewandten Bedingungen unterscheiden sich nur insofern von denen beim Beispiel 1 angewandten, dass die zu ätzenden Proben bei der Ätzung sich etwas ausserhalb des Spulenbereichs befanden. Unter diesen Bedingungen wurde ein vollständiger und sauberer Abtrag des Kupfers erzielt, und es fand keine Redeposition von Kupfer und – bei der Verwendung von Kunststoffsubstraten – keine Polymerabscheidung statt. Da sich die Proben ausserhalb des Bereichs befanden, in welchem sie von im elektrischen Feld der Spule beschleunigten Teilchen getroffen werden können, fand bei diesem Beispiel die Kupferabtragung offensichtlich ausschliesslich über eine chemische Reaktion mit dem Kupfer unter Bildung von leichtflüchtigen Kupferverbindungen statt. (Eine – zusätzliche – physikalische Abtragung des Kupfers soll – im Normalfall – nicht ausgeschlossen werden. Werden beim selektiven Ätzen einer Kupferschicht vertikale Flanken des stehengebliebenen Kupfers angestrebt, so ist es sogar notwendig, dass der Kupferabtrag sowohl chemisch, als auch physikalisch erfolgt.) Die Ergebnisse des Beispiels 2 zeigen auch, dass – da ein physikalischer Abtrag ausgeschlossen ist – eine Wiederabscheidung von Material nicht deshalb nicht festzustellen ist, weil das wiederabgeschiedene Material sofort wieder physikalisch entfernt wird, sondern weil eine solche Wiederabscheidung tatsächlich nicht stattfindet.

## Patentansprüche

1. Verfahren zum Trockenätzen von Kupfer in einer Glimmentladung, welche organische Verbindungen enthält, dadurch gekennzeichnet, dass zum Ätzen Verbindungen mit mindestens einer Methyl- oder Methylen-Gruppe eingesetzt werden.

2. Verfahren nach Anspruch 1, dadurch gekennzeichnet, dass mindestens eine Verbindung der Gruppe Methylchlorid, Methylbromid, Methyljodid, Methanol, Azeton, Dibutandiole und Diazomethan eingesetzt werden.

3. Verfahren nach Anspruch 1 oder 2, dadurch gekennzeichnet, dass bei einer Temperatur des Kupfers im Bereich zwischen 40 und 200°C geätzt wird.

4. Verfahren nach einem der Ansprüche 1 bis 3, dadurch gekennzeichnet, dass das Kupfer mittels Plasmaätzens oder reaktiven Ionenätzens abgetragen wird.

5. Verfahren nach einem der Ansprüche 1 bis 4, dadurch gekennzeichnet, dass das Kupfer selektiv in Gegenwart von Polymeren geätzt wird.

6. Verfahren nach Anspruch 5, dadurch gekennzeichnet, dass das Kupfer vor dem Ätzen teilweise mit einer Polymerschicht maskiert wird.

7. Verfahren nach Anspruch 6, dadurch gekennzeichnet, dass mit einer Schicht aus einem polymeren aus der Gruppe, Negativ- und Positivlacke und Polyimid maskiert wird.

8. Verfahren nach einem der Ansprüche 1 bis 7, dadurch gekennzeichnet, dass Kupfer geätzt wird, welches auf einem Substrat aus Glas, Keramik oder Kunststoff aufgebracht ist.

9. Verfahren nach einem der Ansprüche 1 bis 8, dadurch gekennzeichnet, dass mit einer Methylhalogenid-Verbindung bei einem Druck im Bereich zwischen 0,0133 und 1,33 mbar und einer HF-Leistung im Bereich zwischen 0,5 und 4 W/cm² geätzt wird.

10. Verfahren nach Anspruch 9, dadurch gekennzeichnet, dass mit Methyljodid bei einem Druck von ungefähr 0,04 mbar einer HF-Leistung von ungefähr 0,8 W/cm² und einer Temperatur des Kupfers von ungefähr 50°C geätzt wird.

11. Verfahren nach einem der Ansprüche 1 bis 10, dadurch gekennzeichnet, dass der mindestens eine Methyl- oder Methylen-Gruppe enthaltenden Verbindung Wasserstoff zugemischt wird.

12. Verfahren nach einem der Ansprüche 1 bis 11, dadurch gekennzeichnet, dass die mindestens eine Methyl- oder Methylen-Gruppe enthaltende Verbindung und – gegebenenfalls – der Wasserstoff mit einem inerten Trägergas, beispielsweise mit Argon oder Stickstoff vermischt ist.

13. Verwendung des Verfahrens nach einem der Ansprüche 1 bis 12, zur Herstellung von Kupfermustern, insbesondere von Leiterzügen auf und/oder in Keramikbauteilen und Schaltkarten, von Lötpunkten und der Verdrahtung für Dünnfilmmagnetköpfe.

## Revendications

1. Procédé de gravure du cuivre à sec, dans une décharge luminescente qui contient des composés organiques, caractérisé en ce que l'on utilise, pour la gravure, des composés comportant au moins un groupe méthyle ou méthylène.

2. Procédé conforme à la revendication 1, caractérisé en ce que l'on utilise au moins un composé du groupe constitué par le chlorure de méthyle, le bromure de méthyle, l'iodure de méthyle, le méthanol, l'acétone, le dibutanediol, et le diazométhane.

3. Procédé conforme à la revendication 1 ou 2, caractérisé en ce que l'on effectue la gravure alors que le cuivre est à une température comprise entre 40 et 200°C.

4. Procédé conforme à l'une des revendications 1 à 3, caractérisé en ce que le cuivre est enlevé par gravure au plasma ou par gravure réactive à l'aide d'ions.

5. Procédé conforme à l'une des revendications 1 à 4, caractérisé en ce que le cuivre est gravé sélectivement en présence de polymères.

6. Procédé conforme à la revendication 5, caractérisé en ce que le cuivre, avant la gravure, est masqué partiellement à l'aide d'une couche de polymère.

7. Procédé conforme à la revendication 6, caractérisé en ce que l'on effectue le masquage avec une couche d'un polymère choisi dans le groupe constitué des laques négatives, des laques positives et des polyimides.

8. Procédé conforme à l'une des revendications 1 à 7, caractérisé en ce que l'on grave du cuivre qui est déposé sur un substrat en verre, en céramique ou en matière plastique.

9. Procédé conforme à l'une des revendications 1 à 8, caractérisé en ce que l'on effectue la gravure à l'aide d'un halogénure de méthyle, sous une pression comprise entre 0,0133 et 1,33 mbar, et avec une puissance HF comprise entre 0,5 et 4 W/cm².

10. Procédé conforme à la revendication 9, caractérisé en ce que l'on effectue la gravure avec du iodure de méthyle sous une pression d'environ 0,04 mbar, avec une puissance HF d'environ 0,8 W/cm², le cuivre étant à une température d'environ 50°C.

11. Procédé conforme à l'une des revendications 1 à 10, caractérisé en ce que de l'hydrogène est mélangé au composé contenant au moins un groupe méthyle ou méthylène.

12. Procédé conforme à l'une des revendications 1 à 11, caractérisé en ce que le composé comportant au moins un groupe méthyle ou méthylène et, éventuellement, l'hydrogène sont mélangés avec un gaz vecteur inerte, par exemple de l'argon ou d'azote.

13. Utilisation du procédé conforme à l'une des revendications 1 à 12, pour la fabrication de dessins en cuivre, en particulier de traits conducteurs sur et/ou dans des éléments en céramique et des cartes imprimées, de points de soudure et de câblage pour des têtes magnétiques à film mince.

## Claims

1. Method of copper dry etching in a glow discharge containing organic compounds, characterized in that compounds with at least one methyl or methylene group are used for etching.

2. Method as claimed in claim 1, characterized in that at least one compound selected from the group of methyl chloride, methyl bromide, methyl iodide, methanole, acetone, dibutandioles and diazomethane is used.

3. Method as claimed in claim 1 or 2, characterized in that etching takes place at a copper temperature between 40 and 200°C.

4. Method as claimed in any one of claims 1 to 3, characterized in that the copper is removed by means of plasma etching or reactive ion etching.

5. Method as claimed in any one of claims 1 to 4, characterized in that the copper is etched selectively in the presence of polymers.

6. Method as claimed in claim 5, characterized in that prior to etching the copper is partly masked with a polymeric layer.

7. Method as claimed in claim 6, characterized in that the mask used consists of a layer of a polymer selected from the group of negative and positive resists and polyimide.

8. Method as claimed in any one of claims 1 to 7, characterized in that copper is etched that is applied on a substrate of glass, ceramic, or plastic material.

9. Method as claimed in any one of claims 1 to 8, characterized in that etching takes place with a methyl halide compound at a pressure between 0.0133 and 1.33 mbar and an RF power between 0.5 and 4 W/cm².

10. Method as claimed in claim 9, characterized in that etching takes place with methyl iodide at a pressure of approximately 0.04 mbar, an RF power of approximately 0.8 W/cm², and a copper temperature of approximately 50°C.

11. Method as claimed in any one of claims 1 to 10, characterized in that hydrogen is admixed to the compound containing at least one methyl or methylene group.

12. Method as claimed in any one of claims 1 to 11, characterized in that the compound containing at least one methyl or methylene group, and if necessary the hydrogen are mixed with an inert carrier gas, e.g. with argon or nitrogen.

13. Implementation of the method as claimed in any one of claims 1 to 12, for making copper patterns, particularly conductors on and/or in ceramic components and cards, soldering spots, and the wiring of magnetic thin film heads.